# FASCICULE DE BREVET EUROPEEN

(11) **EP 3 099 148 B1**
(45) Date de publication et mention de la délivrance du brevet: **03.01.2018**
(21) Numéro de dépôt: 15305796.3
(22) Date de dépôt: 27.05.2015
(51) Int. Cl.: H05K 3/46, H05K 1/02, H05K 7/14, H05K 5/02, H02B 1/48, H02G 3/08, H01H 9/02, H05K 1/18, H02G 3/14

(54) **CIRCUIT IMPRIMÉ COMPRENANT UNE ARTICULATION**
GEDRUCKTER SCHALTKREIS, DER EIN GELENK UMFASST
PRINTED CIRCUIT INCLUDING A HINGE

(43) Date de publication de la demande: 30.11.2016
(73) Titulaire: Hager Controls SAS, 67700 Saverne (FR)
(72) Inventeur: PEYRAS, Thierry, 67290 WIMMENAU (FR)
(74) Mandataire: Nuss, Laurent

(56) Documents cités:
- FR-A1- 2 896 081
- US-A- 5 903 441
- US-A1- 2002 051 349
- US-A1- 2007 249 187
- US-A1- 2009 242 240
- US-A1- 2012 106 115
- US-A1- 2013 010 406

## Description

La présente invention relève du domaine de l'installation électrique domestique, et a pour objet un circuit imprimé pour un appareil électrique d'une installation électrique domestique, un appareil électrique destiné à être installé dans une installation électrique domestique et un procédé de montage d'un appareil électrique selon l'invention.

De tels circuits imprimés comprenant un bouton poussoir sont connus. En général, ces boutons poussoirs peuvent être actionnés par un utilisateur en déplaçant une pièce montée mobile dans un boîtier pour venir en appui contre le bouton poussoir du circuit imprimé. Un exemple de l'état de l'art d'un circuit imprimé comprenant un bouton pressoir est divulgué dans le document FR 2 896 081 A1. Le but de la présente invention est de réduire le nombre de pièces d'un appareil électrique d'une installation électrique domestique comprenant un circuit imprimé comportant un bouton poussoir.

A cet effet, l'invention propose un circuit imprimé pour un appareil électrique d'une installation électrique domestique, ledit appareil électrique comprenant un boîtier comportant une saillie et une zone de raccordement, ledit circuit imprimé comprenant une première face, un tronçon principal et un tronçon de raccordement, ledit tronçon principal comprenant un bouton poussoir agencé sur la première face, ledit tronçon de raccordement formant une articulation adaptée pour être raccordée à la zone de raccordement du boîtier de sorte à permettre le pivotement du tronçon principal depuis une position de repos vers une position d'activation autour de l'articulation pour amener le bouton poussoir en appui de fonctionnement contre la saillie du boîtier.

Ainsi, par rapport à un appareil électrique comportant un bouton poussoir classique, le nombre de pièces de l'appareil électrique peut être réduit, ce qui simplifie aussi l'assemblage et réduit les coûts de production.

Selon une possibilité, le tronçon de raccordement est souple ou pliable.

Ainsi, le tronçon de raccordement peut être formé d'un seul tenant avec le tronçon principal tout en formant l'articulation.

Selon une autre possibilité, le circuit imprimé peut comprendre une charnière mécanique reliant le tronçon de raccordement au tronçon principal et fonctionnant selon le principe d'une liaison pivot de sorte à permettre le pivotement du tronçon principal depuis la position de repos vers la position d'activation.

Selon une caractéristique additionnelle possible, le tronçon principal est doté d'une première épaisseur et le tronçon de raccordement est doté d'une deuxième épaisseur inférieure à la première épaisseur.

Selon une possibilité, le tronçon de raccordement peut être formé en réduisant l'épaisseur du tronçon de raccordement par fraisage.

Ainsi, le tronçon de raccordement peut être formé dans le circuit imprimé en mettant à disposition un circuit imprimé d'épaisseur constante et en réduisant cette épaisseur au niveau du tronçon de raccordement par une simple opération de fraisage.

Selon une caractéristique additionnelle possible, le rapport entre la première épaisseur et la deuxième épaisseur est supérieur ou égal à 2, de préférence supérieur ou égal à 4, idéalement supérieur ou égal à 8.

Ainsi, le tronçon de raccordement sera pourvu d'une flexibilité suffisante pour permettre la fonction d'articulation du tronçon de raccordement.

Selon une caractéristique additionnelle possible, le tronçon de connexion électrique est relié au tronçon principal et peut être relié électriquement à un composant électrique de l'appareil électrique.

Selon une possibilité, le tronçon de connexion électrique est doté d'une troisième épaisseur sensiblement égale à la deuxième épaisseur.

Ainsi le tronçon de connexion sera doté d'une flexibilité suffisante pour pouvoir être posé dans le boîtier afin de relier électriquement le circuit imprimé à un composant électrique de l'appareil électrique.

Selon une caractéristique additionnelle possible, le circuit imprimé comprend un capteur capacitif apte à détecter un déplacement d'un doigt d'un utilisateur le long d'une deuxième face du circuit imprimé opposée à la première face du circuit imprimé.

Ainsi, un utilisateur peut envoyer des commandes à l'appareil électrique à l'aide de son doigt.

Selon une possibilité, le tronçon de raccordement comprend au moins un premier orifice essentiellement rond et un deuxième orifice essentiellement oblong, le premier orifice et le deuxième orifice étant chacun apte à recevoir un épaulement du boîtier afin d'aligner le circuit imprimé dans le boîtier dans une position de raccordement.

Ainsi, le circuit imprimé peut être aligné de façon simple dans le boîtier dans sa position de raccordement.

Selon une possibilité, le circuit imprimé est doté d'une couche de vernis recouvrant celui-ci le long de la première face.

Selon une caractéristique additionnelle possible, le boîtier comprend en outre au moins une butée et le tronçon principal comprend au moins une zone de butée pouvant venir en appui contre la au moins une butée pour empêcher un pivotement du tronçon principal autour de l'articulation éloignant le bouton poussoir de la saillie au-delà de la position de repos afin de maintenir le circuit imprimé dans le boîtier.

Ainsi, l'envergure du pivotement du tronçon principal peut être limitée entre une première position dans laquelle la zone butée vient en appui contre la butée et une deuxième position dans laquelle le bouton poussoir vient en appui contre la saillie.

Selon une possibilité, la au moins une zone de butée est formée par un évidement.

Selon une possibilité, l'évidement est formé par fraisage.

Selon une caractéristique additionnelle possible, la zone de butée est formée dans le tronçon principal du côté opposé au tronçon de raccordement.

L'invention a également pour objet un appareil électrique destiné à être installé dans une installation électrique domestique, comprenant un boîtier et un circuit imprimé selon l'invention. Ledit boîtier comprend une saillie et le tronçon de raccordement du circuit imprimé est raccordé au boîtier pour former une articulation autour de laquelle peut pivoter le tronçon principal depuis une position de repos vers une position d'activation pour amener le bouton poussoir en appui de fonctionnement contre la saillie du boîtier.

Selon une possibilité, la saillie est formée d'une vis vissée dans le boîtier. De préférence, le vissage de la vis dans le boîtier forme un taraudage dans le boîtier.

Ainsi, une récupération de tolérances lors de la fabrication et/ou de l'assemblage de l'appareil et/ou un réglage du bouton poussoir peut être effectuée de façon simple.

Selon une possibilité, la vis peut être nommée vis de réglage.

Selon une caractéristique additionnelle possible, le boîtier comprend un élément de maintien comportant un tronçon de maintien venant en appui contre le tronçon de raccordement afin de relier ce dernier au boîtier pour former l'articulation.

Ainsi, le circuit imprimé peut être monté pivotant dans le boîtier de façon sûre et durable.

Selon une caractéristique additionnelle possible, l'élément de maintien est formé d'une vitre.

Selon une possibilité, le boîtier comprend au moins deux épaulements, le tronçon de raccordement comprenant au moins un premier orifice essentiellement rond et un deuxième orifice essentiellement oblong, le premier orifice et le deuxième orifice recevant chacun l'un des épaulements du boîtier afin d'aligner le circuit imprimé dans le boîtier dans une position de raccordement.

Ainsi, l'alignement du circuit électrique dans le boîtier peut être effectué de façon précise et simple.

L'invention a également pour objet un procédé de montage d'un appareil électrique selon l'invention. Le procédé comprend les étapes suivantes qui consistent à :
a) mettre à disposition le boîtier de l'appareil électrique ;
b) mettre à disposition le circuit imprimé de l'appareil électrique ;
c) relier le tronçon de raccordement du circuit imprimé au boîtier pour former une articulation autour de laquelle peut pivoter le tronçon principal du circuit imprimé pour amener le bouton poussoir du tronçon principal depuis une position de repos vers une position d'activation en appui de fonctionnement contre la saillie du boîtier.

Ainsi, un appareil électrique comportant un nombre de pièces réduites peut être obtenu et le procédé de montage peut être simplifié.

Selon une caractéristique additionnelle possible, le procédé comprend en outre les étapes suivantes consistant à :
c1) introduire un premier des épaulements du boîtier dans le deuxième orifice du tronçon de raccordement du circuit imprimé afin de relier le tronçon de raccordement du circuit imprimé au boîtier pour former l'articulation;
c2) introduire un deuxième des épaulements du boîtier dans le premier orifice du tronçon de raccordement du circuit imprimé afin de relier le tronçon de raccordement du circuit imprimé au boîtier pour former l'articulation.

Ainsi, le circuit imprimé peut être aligné de façon simple dans le boîtier dans sa position de raccordement.

Selon une caractéristique additionnelle possible, le procédé comprend en outre les étapes suivantes consistant à :
b1) mettre à disposition l'élément de maintien ;
c5) mettre en appui le tronçon de maintien de l'élément de maintien contre le tronçon de raccordement du circuit imprimé afin de relier le tronçon de raccordement du circuit imprimé au boîtier pour former l'articulation.

Ainsi, le tronçon de raccordement peut être maintenu dans la position de raccordement de façon simple.

Selon une caractéristique additionnelle possible, le procédé comprend en outre l'étape suivante qui consiste à :
c4) appliquer un adhésif sur le tronçon de maintien de l'élément de maintien et/ou sur l'élément de maintien et/ou sur le tronçon de raccordement du circuit imprimé et/ou sur le boîtier afin d'adhérer le tronçon de maintien de l'élément de maintien au tronçon de raccordement du circuit imprimé.

Ainsi, le circuit imprimé peut être maintenu dans le boîtier dans la position de raccordement de façon simple et durable.

Selon une possibilité, le procédé comprend en outre l'étape suivante qui consiste à :
c3) juxtaposer au moins une zone de butée du tronçon principal à au moins une butée du boîtier afin d'empêcher un pivotement du tronçon principal autour de l'articulation éloignant le bouton poussoir de la saillie au-delà de la position de repos et de maintenir le circuit imprimé dans le boîtier.

Ainsi, le circuit imprimé peut être entièrement maintenu dans le boîtier de façon simple, tout en permettant le pivotement du tronçon principal autour de l'articulation.

L'invention sera mieux comprise, grâce à la description ci-après, présentant en outre les avantages supplémentaires de l'invention et qui se rapporte à un mode de réalisation préféré, donné à titre d'exemple non limitatif, et expliqué avec référence aux dessins schématiques annexés, dans lesquels :
- les figures 1 et 2 montrent différentes vues d'un circuit imprimé selon l'invention ;
- la figure 3 montre une vue en perspective de l'appareil électrique selon l'invention, et ;
- la figure 4 montre une vue en explosion de l'appareil électrique selon l'invention ;
- la figure 5 montre une vue en perspective d'un appareil électrique selon l'invention partiellement découpé en faisant apparaître le bouton poussoir et la vis de réglage ;
- la figure 6 montre une vue de détail de la partie A indiquée sur la figure 5.

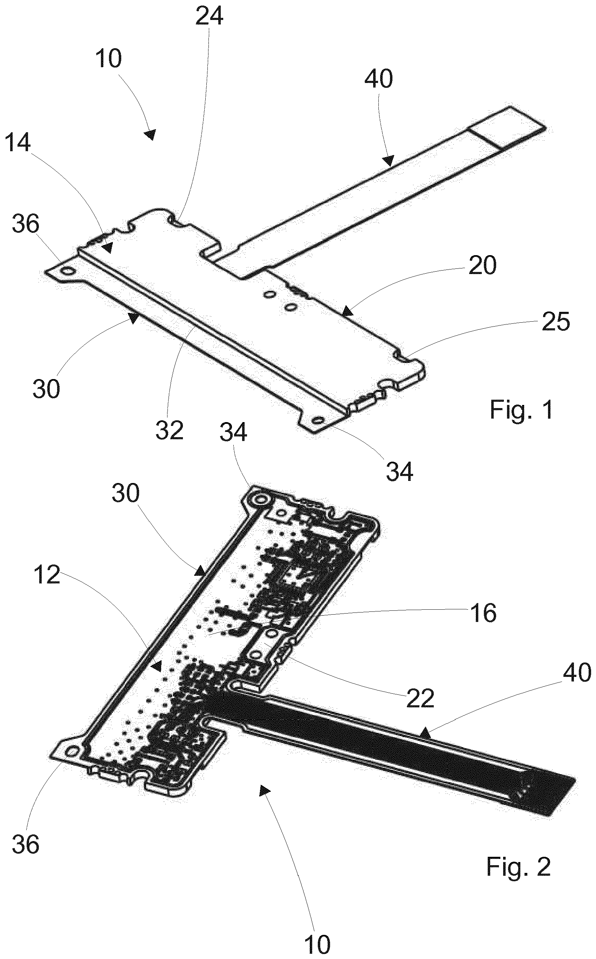

La figure 1 divulgue un circuit imprimé 10 selon l'invention pour un appareil électrique 100 d'une installation électrique domestique.

La figure 1 divulgue le circuit imprimé 10 avec une vue en perspective sur une deuxième face 14 de celui-ci. Le circuit imprimé 10 comprend un tronçon principal 20 et un tronçon de raccordement 30. Le tronçon de raccordement 30 forme une articulation 32 adaptée pour être raccordée à une zone de raccordement 114 d'un boîtier 110 de l'appareil électrique 100. L'articulation 32 permet le pivotement du tronçon principal 20 autour de l'articulation 32 depuis une position de repos vers une position d'activation.

Comme le divulgue figure 2, le tronçon principal 20 comprend un bouton poussoir 22 agencé sur une première face 12 du circuit imprimé 10. L'articulation 32 permet le pivotement du tronçon principal 20 autour de l'articulation 32 pour amener le bouton poussoir 22 en appui de fonctionnement contre une saillie 112 du boîtier 110. Le bouton poussoir 22 est en appui de fonctionnement contre saillie 112 lorsque le tronçon principal 20 est dans la position d'activation. Le tronçon principal peut en outre comprendre deux boutons poussoirs additionnels (non représentés dans les figures) qui sont de préférence agencés de part et d'autre du bouton poussoir 22 du côté de la première face 12.

Le tronçon de raccordement 30 peut être souple ou pliable pour former l'articulation. La souplesse et la pliabilité du tronçon de raccordement 30 peut être obtenu, comme le divulgue la figure 1, en dotant le tronçon de raccordement 30 d'une deuxième épaisseur inférieure à une première épaisseur du tronçon principal 20. Un tel tronçon de raccordement 30 peut être formé dans le circuit imprimé 10 en partant d'un circuit imprimé 10 doté d'une épaisseur uniforme et en amincissant le circuit imprimé 10 au niveau du tronçon de raccordement 30. Cet amincissement peut être obtenu par un fraisage de tronçon de raccordement 30.

Selon une alternative non divulguée dans les figures, le circuit imprimé 10 peut comprendre une charnière mécanique reliant le tronçon de raccordement 30 au tronçon principal 20 et fonctionnant selon le principe d'une liaison pivot de sorte à permettre le pivotement du tronçon principal 20 depuis la position de repos vers la position d'activation.

Comme le divulguent les figures 1 et 2, le circuit imprimé 10 peut être doté d'un tronçon de connexion électrique 40 relié au tronçon principal 20 et pouvant être relié électriquement à un composant électrique de l'appareil électrique 100. Le tronçon de connexion 40 peut être relié au tronçon principal 20 d'un côté opposé au tronçon de raccordement 30. Le tronçon de connexion 40 peut être doté d'une troisième épaisseur sensiblement égale à la deuxième épaisseur du tronçon de raccordement 30. Le tronçon de connexion électrique 40 peut être formé de façon analogue au tronçon de raccordement 30. Le tronçon de connexion électrique 40 est alors initialement doté de la même épaisseur que le tronçon principal 20. La troisième épaisseur du tronçon de connexion 40 peut donc être obtenue par fraisage.

De préférence, la deuxième face 14 du circuit imprimé 10 comprend les composants électriques du circuit imprimé 10. Le circuit imprimé 10 peut être doté d'un capteur capacitif 16 apte à détecter un déplacement d'un doigt d'un utilisateur le long de la deuxième face 14 du circuit imprimé 10. Le capteur capacitif 16 peut être agencé sur la première face 12 du circuit imprimé 10.

Comme le divulguent les figures 1 et 2, le tronçon de raccordement 30 comprend au moins un premier orifice 34 essentiellement rond et un deuxième orifice 36 essentiellement oblong. Le premier orifice 34 et le deuxième orifice 36 peuvent chacun être apte à recevoir un épaulement 116, 117 du boîtier 110 afin d'aligner le circuit imprimer 10 dans le boîtier 110 dans une position de raccordement. L'alignement du circuit imprimé 10 dans le boîtier 110 est essentiellement réalisé par le premier orifice 34 essentiellement rond, lorsqu'il reçoit l'un des épaulements 116, 117. Le deuxième orifice 36 essentiellement oblong peut alors recevoir l'autre des épaulements 116, 117, la forme oblongue du deuxième orifice 36 servant alors essentiellement à récupérer les tolérances de fabrication du boîtier 110.

Le circuit imprimé 110 peut être doté d'une couche de vernis 18 recouvrant celui-ci le long de la première face 12.

Comme le divulgue la figure 1, le tronçon principal 20 peut comprendre au moins une, de préférence au moins deux zones de butée 24, 25 pouvant venir en appui contre au moins une butée 118, 119 du boîtier 110 pour empêcher un pivotement du tronçon principal 20 autour de l'articulation 32 éloignant le bouton poussoir 22 de la saillie 112 au-delà de la position de repos, ceci afin de maintenir le circuit imprimé 10 dans le boîtier 110. Les butées 118, 119 sont en contact avec les zones de butée 24, 25 lorsque le tronçon principal est dans la position de repos. La zone de butée 24, 25 peut être formée par un évidement obtenu de préférence par un fraisage du tronçon principal 20 du côté de la deuxième face 14.

Selon une possibilité, le tronçon de raccordement 30, le tronçon de connexion électrique 40 et les zones de butée 24, 25 sont sensiblement dotés de la même épaisseur et sont de préférence obtenus par une seule opération de fraisage.

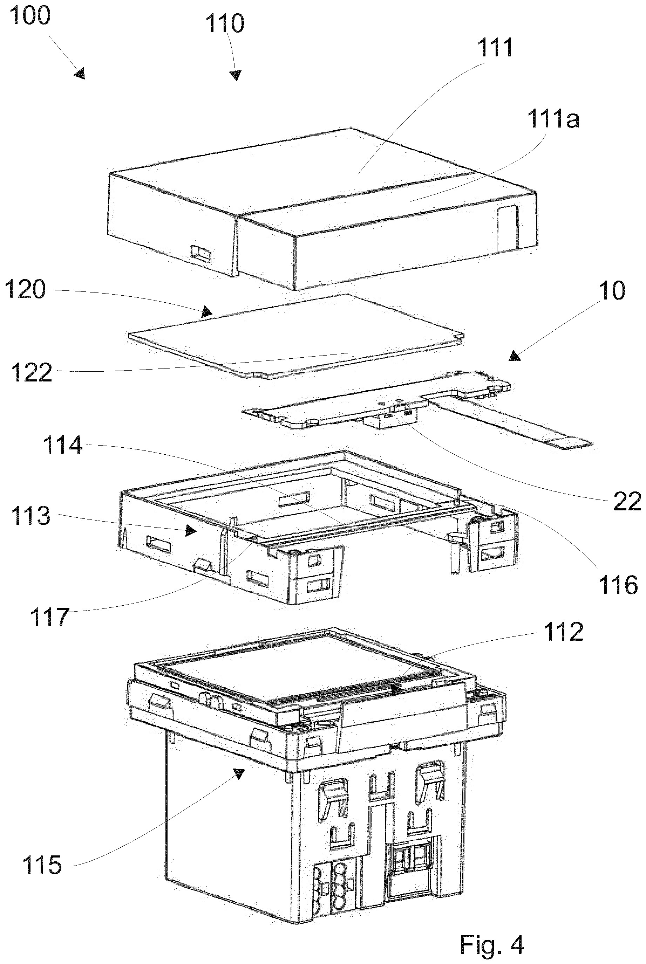

La figure 4 divulgue une vue en explosion de l'appareil électrique 100 selon l'invention. L'appareil électrique 100 comprend un circuit imprimé 10 selon l'invention et un boîtier 110. Le boîtier 110 comprend une base 115, un support 113 et un recouvrement 111. Le support 113 est doté d'une zone de raccordement 114, à laquelle peut être raccordé le tronçon de raccordement 30 pour former l'articulation 32. Les épaulements 116, 117 sont de préférence agencés à la zone de raccordement 114.

Le recouvrement 111 d'une zone de basculement 111a apte à, dans l'appareil électrique 100, parcourir un pivotement parallèle au pivotement du tronçon principal 20 du circuit imprimé 10. La zone de basculement 111a peut être raccordée au tronçon principal 20 du circuit imprimé 10 pour faire pivoter le tronçon principal 20 autour de l'articulation 32 afin de mettre en appui de fonctionnement le bouton poussoir 22 contre la saillie 112 du boîtier lorsqu'un utilisateur exerce une pression sur la zone de basculement 111a.

Le support 113 peut être relié à la base 115 par encliquetage.

L'appareil électrique 100 peut également comprendre un élément de maintien 120 présentant de préférence essentiellement la forme d'une plaque. L'élément de maintien 120 peut être formé d'une vitre.

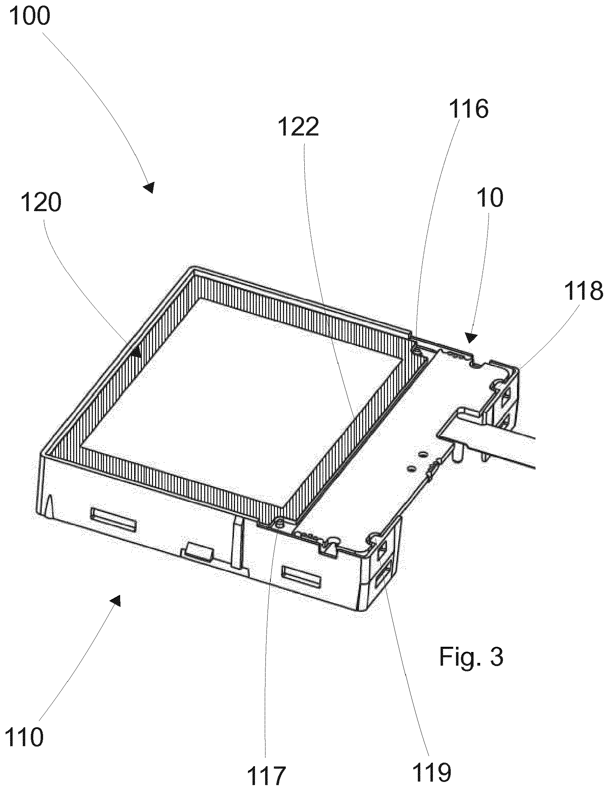

Comme le divulguent les figures 3 et 4, l'élément de maintien 120 peut comprendre un tronçon de maintien 122 venant en appui contre le tronçon de raccordement 30 du circuit imprimé 10 afin de relier le tronçon de raccordement 30 au boîtier 110 pour former l'articulation 32. L'élément de maintien 120 peut être joint au boîtier 110 et/ou au support 113 et/ou au tronçon de raccordement 30 par liaison à matière adhésive, à l'aide d'un colle, par exemple.

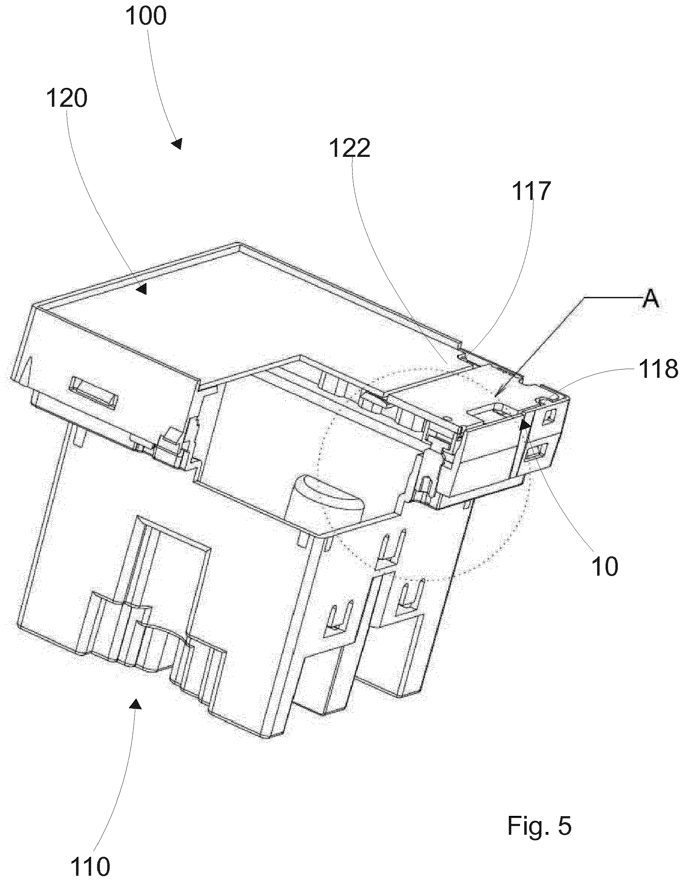

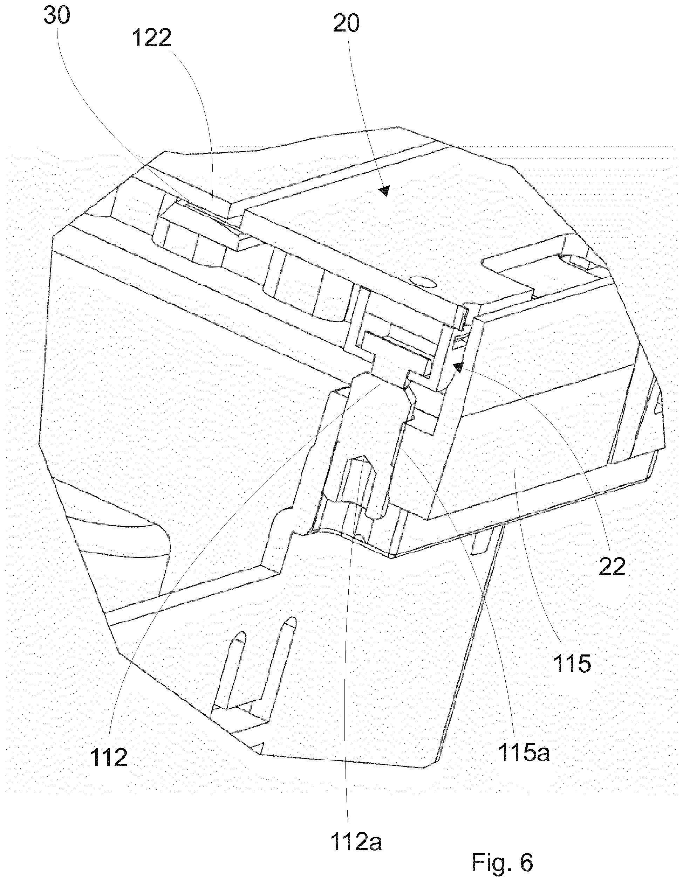

Comme le divulguent notamment les figures 5 et 6, la saillie 112 du boîtier 110 contre laquelle le bouton poussoir 22 du circuit imprimé 10 peut venir en appui de fonctionnement est formée d'une vis 112a introduite dans un taraudage 115a formé dans le boîtier 110, de préférence dans la base 115 du boîtier 110. Selon une possibilité, le taraudage 115a est formé en vissant la vis 112a dans le boîtier 110, de préférence dans la base 115 du boîtier 110. Selon une possibilité, la vis 112a peut être nommée vis de réglage.

L'invention a également pour objet un procédé de montage d'un appareil électrique 100 selon l'invention. Le procédé de montage comprend les étapes suivantes qui consistent à :
a) mettre à disposition le boîtier 110 de l'appareil électrique 100 ;
b) mettre à disposition le circuit imprimé 10 de l'appareil électrique 100 ;
c) relier le tronçon de raccordement 30 du circuit imprimé 10 au boîtier 110 pour former une articulation 32 autour de laquelle peut pivoter le tronçon principal 20 du circuit imprimé 10 pour amener le bouton poussoir 22 du tronçon principal 20 depuis une position de repos vers une position d'activation en appui de fonctionnement contre la saillie 112 du boîtier 110.

De préférence l'étape b) est effectuée après l'étape a). De préférence l'étape c) est effectuée après les étapes a) et/ou b).

Le procédé peut en outre comprendre les étapes suivantes consistant à :
c1) introduire un premier des épaulements 116, 117 du boîtier 110 dans le premier orifice 34 du tronçon de raccordement 30 du circuit imprimé 10 afin de relier le tronçon de raccordement 30 du circuit imprimé 10 au boîtier 110 pour former l'articulation 32 ;
c2) introduire un deuxième des épaulements 116, 117 du boîtier 110 dans le deuxième orifice du tronçon de raccordement 30 du circuit imprimé 10 afin de relier le tronçon de raccordement 30 du circuit imprimé 10 au boîtier 110 pour former l'articulation 32.

De préférence, les étapes c1) et/ou c2) sont effectuées après l'étape b).

Le procédé peut également comprendre en outre les étapes suivantes consistant à :
b1) mettre à disposition l'élément de maintien 120 ;
c5) mettre en appui le tronçon de maintien 122 de l'élément de maintien 120 contre le tronçon de raccordement 30 du circuit imprimé 10 afin de relier le tronçon de raccordement 30 du circuit imprimé 10 au boîtier 110 pour former l'articulation.

De préférence, l'étape b1) est effectuée après l'étape a).

De préférence, l'étape b1) est effectuée avant les étapes c), c1), c2) et/ou c5).

De préférence, l'étape c5) est effectuée après les étapes c1) et/ou c2).

Le procédé de montage peut comprendre en outre l'étape suivante consistant à :
c4) appliquer un adhésif sur le tronçon de maintien 122 de l'élément de maintien 120 et/ou sur l'élément de maintien 120 et/ou sur le tronçon de raccordement 30 du circuit imprimé 10 et/ou sur le boîtier 110 et/ou sur le support 113 du boîtier 110 afin d'adhérer le tronçon de maintien 122 de l'élément de maintien 120 au tronçon de raccordement 30 du circuit imprimé 10.

De préférence, l'étape c4) est effectuée avant l'étape c5).

De préférence, l'étape c4) est effectuée après les étapes a), b), b1), c1) et/ou c2).

Le procédé de montage peut comprendre en outre l'étape suivante consistant à :
c3) juxtaposer au moins une zone de butée 24, 25 du tronçon principal 20 à au moins une butée 118, 119 du boîtier 110 afin d'empêcher un pivotement du tronçon principal 20 autour de l'articulation 32 éloignant le bouton poussoir 22 de la saillie 112 au-delà de la position de repos et de maintenir le circuit imprimé 10 dans le boîtier 110.

De préférence, l'étape c3) est effectuée avant les étapes c4) et c5).

De préférence, l'étape c3) est effectuée après les étapes a), b), b1), c), c1) et/ou c2).

Le procédé de montage peut en outre comprendre l'étape suivante consistant à :
d) tourner la vis 112a dans le boîtier 110, de préférence dans la base 115 du boîtier 110, afin de former un taraudage 115a.

Le procédé de montage peut en outre comprendre l'étape suivante consistant à :
e) tourner la vis dans le boîtier 110, de préférence dans la base 115 du boîtier 110, afin d'affiner le réglage du bouton poussoir 22 et/ou d'égaliser des tolérances de fabrication et/ou d'assemblage de l'appareil 100.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Circuit imprimé (10) pour un appareil électrique (100) d'une installation électrique domestique, ledit appareil électrique (100) comprenant un boîtier (110) comportant une saillie (112) et une zone de raccordement (114), ledit circuit imprimé (10) comprenant une première face (12), un tronçon principal (20) et un tronçon de raccordement (30), ledit tronçon principal (20) comprenant un bouton poussoir (22) agencé sur la première face (12), ledit tronçon de raccordement (30) formant une articulation (32) adaptée pour être raccordée à la zone de raccordement (114) du boîtier (110) de sorte à permettre le pivotement du tronçon principal (20) depuis une position de repos vers une position d'activation autour de l'articulation (32) pour amener le bouton poussoir (22) en appui de fonctionnement contre la saillie (112) du boîtier (110).

2. Circuit imprimé selon la revendication 1, **caractérisé en ce que** le tronçon de raccordement (30) est souple ou pliable.

3. Circuit imprimé selon l'une quelconque des revendications 1 ou 2, **caractérisé en ce que** le tronçon principal (20) est doté d'une première épaisseur et le tronçon de raccordement (30) est doté d'une deuxième épaisseur inférieure à la première épaisseur, le rapport entre la première épaisseur et la deuxième épaisseur étant préférentiellement supérieur ou égal à 2.

4. Circuit imprimé selon l'une quelconque des revendications 1 à 3, **caractérisé en ce qu'**il comprend en outre un capteur capacitif (16) apte à détecter un déplacement d'un doigt d'un utilisateur le long d'une deuxième face (14) du circuit imprimé (10) opposée à la première face (12) du circuit imprimé (10).

5. Circuit imprimé selon l'une quelconque des revendications 1 à 4, **caractérisé en ce que** le tronçon de raccordement (30) comprend au moins un premier orifice (34) essentiellement rond et un deuxième orifice (36) essentiellement oblong, le premier orifice (34) et le deuxième orifice (36) étant chacun apte à recevoir un épaulement (116, 117) du boîtier (110) afin d'aligner le circuit imprimé (10) dans le boîtier (110) dans une position de raccordement.

6. Circuit imprimé selon l'une quelconque des revendications 1 à 5, **caractérisé en ce que** le boîtier (110) comprend en outre au moins une butée (118, 119) et le tronçon principal (20) comprend au moins une zone de butée (24, 25) pouvant venir en appui contre la au moins une butée (118, 119) pour empêcher un pivotement du tronçon principal (20) autour de l'articulation (32) éloignant le bouton poussoir (22) de la saillie (112) au-delà de la position de repos afin de maintenir le circuit imprimé (10) dans le boîtier (110).

7. Appareil électrique destiné à être installé dans une installation électrique domestique, comprenant un boîtier (110) et un circuit imprimé (10) selon l'une quelconque des revendications 1 à 6, ledit boîtier (110) comprenant une saillie (112), le tronçon de raccordement (30) du circuit imprimé (10) étant raccordé au boîtier (110) pour former une articulation (32) autour de laquelle peut pivoter le tronçon principal (20) depuis une position de repos vers une position d'activation pour amener le bouton poussoir (22) en appui de fonctionnement contre la saillie (112) du boîtier (110).

8. Appareil électrique selon la revendication 7, **caractérisé en ce que** la saillie (112) est formée d'une vis (112a) vissée dans le boîtier (110).

9. Appareil électrique selon l'une quelconque des revendications 7 ou 8, **caractérisé en ce que** le boîtier (110) comprend un élément de maintien (120) comportant un tronçon de maintien (122) venant en appui contre le tronçon de raccordement (30) afin de relier ce dernier au boîtier (110) pour former l'articulation (32), l'élément de maintien (120) étant préférentiellement formé d'une vitre.

10. Appareil électrique selon l'une quelconque des revendications 6 à 9, **caractérisé en ce que** le boîtier comprend au moins deux épaulements (116, 117), le tronçon de raccordement comprenant au moins un premier orifice (34) essentiellement rond et un deuxième orifice (36) essentiellement oblong, le premier orifice (34) et le deuxième orifice (36) recevant chacun l'un des épaulement (116, 117) du boîtier (110) afin d'aligner le circuit imprimé (10) dans le boîtier (110) dans une position de raccordement.

11. Procédé de montage d'un appareil électrique (100) selon l'une quelconque des revendications 6 à 10, **caractérisé par** les étapes suivantes qui consistent à :
a) mettre à disposition le boîtier (110) de l'appareil électrique (100) ;
b) mettre à disposition le circuit imprimé (10) de l'appareil électrique (100) ;
c) relier le tronçon de raccordement (30) du circuit imprimé (10) au boîtier (110) pour former une articulation (32) autour de laquelle peut pivoter le tronçon principal (20) du circuit imprimé (10) pour amener le bouton poussoir (22) du tronçon principal (20) depuis une position de repos vers une position d'activation en appui de fonctionnement contre la saillie (112) du boîtier (110).

12. Procédé de montage d'un appareil électrique selon la revendication 11, ledit appareil électrique consistant en un appareil électrique tel que définit dans la revendication 10, procédé, **caractérisé en ce qu'**il comprend en outre les étapes suivantes consistant à :
c1) introduire un premier des épaulements (116, 117) du boîtier (110) dans le deuxième orifice (36) du tronçon de raccordement (30) du circuit imprimé (10) afin de relier le tronçon de raccordement (30) du circuit imprimé (10) au boîtier pour former l'articulation (32) ;
c2) introduire un deuxième des épaulements (116, 117) du boîtier (110) dans le premier orifice (34) du tronçon de raccordement (30) du circuit imprimé (10) afin de relier le tronçon de raccordement (30) du circuit imprimé (10) au boîtier (110) pour former l'articulation (32).

13. Procédé de montage d'un appareil électrique selon l'une quelconque des revendications 11 ou 12, ledit appareil électrique consistant en un appareil électrique tel que définit dans l'une des revendications 9 ou 10, procédé **caractérisé en ce qu'**il comprend en outre les étapes suivantes consistant à :
b1) mettre à disposition l'élément de maintien (120) ;
c5) mettre en appui le tronçon de maintien (122) de l'élément de maintien (120) contre le tronçon de raccordement (30) du circuit imprimé (10) afin de relier le tronçon de raccordement (30) du circuit imprimé (10) au boîtier (110) pour former l'articulation (32).

14. Procédé de montage selon la revendication 13, **caractérisé en ce qu'**il comprend en outre l'étape suivante consistant à :
c4) appliquer un adhésif sur le tronçon de maintien (122) de l'élément de maintien (120) et/ou sur l'élément de maintien (120) et/ou sur le tronçon de raccordement (30) du circuit imprimé (10) et/ou sur le boîtier (110) afin d'adhérer le tronçon de maintien (122) de l'élément de maintien (120) au tronçon de raccordement (30) du circuit imprimé (10).

15. Procédé de montage selon l'une quelconque des revendications 11 à 13, **caractérisé en ce qu'**il comprend en outre l'étape suivante consistant à :
c3) juxtaposer au moins une zone de butée (24, 25) du tronçon (20) principal à au moins une butée (118, 119) du boîtier (110) afin d'empêcher un pivotement du tronçon principal (20) autour de l'articulation (32) éloignant le bouton poussoir (22) de la saillie (112) au-delà de la position de repos et de maintenir le circuit imprimé (10) dans le boîtier (110).

## Patentansprüche

1. Gedruckte Schaltung (10) für ein elektrisches Gerät (100) einer elektrischen Hausinstallation, wobei das elektrische Gerät (100) ein Gehäuse (110) mit einem Vorsprung (112) und einen Anschlussbereich (114) aufweist, wobei die gedruckte Schaltung (10) eine erste Seite (12), einen Hauptabschnitt (20) und einen Anschlussabschnitt (30) aufweist, wobei der Hauptabschnitt (20) eine Drucktaste (22) aufweist, die an der ersten Seite (12) angeordnet ist, wobei der Anschlussabschnitt (30) eine Anlenkung (32) bildet, die dazu ausgelegt ist, an den Anschlussbereich (114) des Gehäuses (110) so angeschlossen zu werden, dass sie die Schwenkbewegung des Hauptabschnitts (20) aus einer Ruhestellung in eine Aktivierungsstellung um die Anlenkung (32) herum gestattet, um die Drucktaste (22) betriebsmäßig in Anlage an den Vorsprung (112) des Gehäuses (110) zu bringen.

2. Gedruckte Schaltung nach Anspruch 1, **dadurch gekennzeichnet, dass** der Anschlussabschnitt (30) nachgiebig bzw. biegsam ist.

3. Gedruckte Schaltung nach einem der Ansprüche 1 oder 2, **dadurch gekennzeichnet, dass** der Hauptabschnitt (20) mit einer ersten Materialstärke versehen ist und der Anschlussabschnitt (30) mit einer zweiten Materialstärke versehen ist, die geringer als die erste Materialstärke ist, wobei das Verhältnis zwischen erster und zweiter Materialstärke vorzugsweise höher oder gleich 2 ist.

4. Gedruckte Schaltung nach einem der Ansprüche 1 bis 3, **dadurch gekennzeichnet, dass** sie ferner einen kapazitiven Sensor (16) aufweist, der dazu geeignet ist, eine Bewegung eines Fingers von einem Benutzer entlang einer zweiten Seite (14) der gedruckten Schaltung (10) zu erfassen, die der ersten Seite (12) der gedruckten Schaltung (10) gegenüberliegt.

5. Gedruckte Schaltung nach einem der Ansprüche 1 bis 4, **dadurch gekennzeichnet, dass** der Anschlussabschnitt (30) zumindest eine im Wesentlichen runde, erste Öffnung (34) und eine im Wesentlichen längliche, zweite Öffnung (36) aufweist, wobei die erste Öffnung (34) und die zweite Öffnung (36) jeweils dazu geeignet sind, eine Schulter (116, 117) des Gehäuses (110) aufzunehmen, um die gedruckte Schaltung (10) in dem Gehäuse (110) in einer Anschlussstellung auszurichten.

6. Gedruckte Schaltung nach einem der Ansprüche 1 bis 5, **dadurch gekennzeichnet, dass** das Gehäuse (110) ferner zumindest einen Anschlag (118, 119) aufweist und der Hauptabschnitt (20) zumindest einen Anschlagbereich (24, 25) aufweist, der in Anlage an den zumindest einen Anschlag (118, 119) gelangen kann, um eine Schwenkbewegung des Hauptabschnitts (20) um die Anlenkung (32) herum zu verhindern, mit welcher die Drucktaste (22) von dem Vorsprung (112) über die Ruhestellung hinaus entfernt würde, damit die gedruckte Schaltung (10) in dem Gehäuse (110) gehalten wird.

7. Elektrisches Gerät, das dazu bestimmt ist, in eine elektrische Hausinstallation installiert zu werden, enthaltend ein Gehäuse (110) und eine gedruckte Schaltung (10) nach einem der Ansprüche 1 bis 6, wobei das Gehäuse (110) einen Vorsprung (112) aufweist, wobei der Anschlussabschnitt (30) der gedruckten Schaltung (10) an das Gehäuse (110) angeschlossen ist, um eine Anlenkung (32) zu bilden, um welche der Hauptabschnitt (20) aus einer Ruhestellung in eine Aktivierungsstellung schwenken kann, um die Drucktaste (22) betriebsmäßig in Anlage an den Vorsprung (112) des Gehäuses (110) zu bringen.

8. Elektrisches Gerät nach Anspruch 7, **dadurch gekennzeichnet, dass** der Vorsprung (112) aus einer in das Gehäuse (110) eingeschraubten Schraube (112a) gebildet ist.

9. Elektrisches Gerät nach einem der Ansprüche 7 oder 8, **dadurch gekennzeichnet, dass** das Gehäuse (110) ein Halteelement (120) aufweist, das einen Halteabschnitt (122) enthält, der in Anlage an den Anschlussabschnitt (30) gelangt, um letzteren mit dem Gehäuse (110) zu verbinden, um die Anlenkung (32) zu bilden, wobei das Halteelement (120) vorzugsweise aus einer Glasscheibe gebildet ist.

10. Elektrisches Gerät nach einem der Ansprüche 6 bis 9, **dadurch gekennzeichnet, dass** das Gehäuse zumindest zwei Schultern (116, 117) aufweist, wobei der Anschlussabschnitt zumindest eine im Wesentlichen runde, erste Öffnung (34) und eine im Wesentlichen längliche, zweite Öffnung (36) aufweist, wobei die erste Öffnung (34) und die zweite Öffnung (36) jeweils eine der Schultern (116, 117) des Gehäuses (110) aufnehmen, um die gedruckte Schaltung (10) in dem Gehäuse (110) in einer Anschlussstellung auszurichten.

11. Verfahren zur Montage eines elektrischen Geräts (100) nach einem der Ansprüche 6 bis 10, **gekennzeichnet durch** die nachfolgenden Schritte:
a) Bereitstellen des Gehäuses (110) des elektrischen Geräts (100);
b) Bereitstellen der gedruckten Schaltung (10) des elektrischen Geräts (100);
c) Verbinden des Anschlussabschnitts (30) der gedruckten Schaltung (10) mit dem Gehäuse (110), um eine Anlenkung (32) zu bilden, um welche herum der Hauptabschnitt (20) der gedruckten Schaltung (10) schwenken kann, um die Drucktaste (22) des Hauptabschnitts (20) aus einer Ruhestellung in eine Aktivierungsstellung in betriebsmäßiger Anlage am Vorsprung (112) des Gehäuses (110) zu bringen.

12. Verfahren zur Montage eines elektrischen Geräts nach Anspruch 11, wobei das elektrische Gerät aus einem elektrischen Gerät wie in Anspruch 10 definiert besteht, **dadurch gekennzeichnet, dass** es ferner die nachfolgenden Schritte umfasst:
c1) Einführen einer erster der Schultern (116, 117) des Gehäuses (110) in die zweite Öffnung (36) des Anschlussabschnitts (30) der gedruckten Schaltung (10), um den Anschlussabschnitt (30) der gedruckten Schaltung (10) mit dem Gehäuse zu verbinden, um die Anlenkung (32) zu bilden;
c2) Einführen einer zweiter der Schultern (116, 117) des Gehäuses (110) in die erste Öffnung (34) des Anschlussabschnitts (30) der gedruckten Schaltung (10), um den Anschlussabschnitt (30) der gedruckten Schaltung (10) mit dem Gehäuse (110) zu verbinden, um die Anlenkung (32) zu bilden.

13. Verfahren zur Montage eines elektrischen Geräts nach einem der Ansprüche 11 oder 12, wobei das elektrische Gerät aus einem elektrischen Gerät wie in einem der Ansprüche 9 oder 10 definiert besteht, **dadurch gekennzeichnet, dass** es ferner nachfolgende Schritte umfasst:
b1) Bereitstellen des Halteelements (120);
c5) Bringen des Halteabschnitts (122) des Halteelements (120) in Anlage an den Anschlussabschnitt (30) der gedruckten Schaltung (10), um den Anschlussabschnitt (30) der gedruckten Schaltung (10) mit dem Gehäuse (110) zu verbinden, um die Anlenkung (32) zu bilden.

14. Verfahren zur Montage nach Anspruch 13, **dadurch gekennzeichnet, dass** es ferner den nachfolgenden Schritt umfasst:
c4) Auftragen eines Haftmittels auf den Halteabschnitt (122) des Halteelements (120) und/oder auf das Halteelement (120) und/oder auf den Anschlussabschnitt (30) der gedruckten Schaltung (10) und/oder auf das Gehäuse (110), um den Halteabschnitt (122) des Halteelements (120) zum Anhaften am Anschlussabschnitt (30) der gedruckten Schaltung (10) zu bringen.

15. Verfahren zur Montage nach einem der Ansprüche 11 bis 13, **dadurch gekennzeichnet, dass** es ferner den nachfolgenden Schritt umfasst:
c3) Nebeneinanderlegen von zumindest einem Anschlagbereich (24, 25) des Hauptabschnitts (20) an zumindest einen Anschlag (118, 119) des Gehäuses (110), um eine Schwenkbewegung des Hauptabschnitts (20) um die Anlenkung (32) herum zu verhindern, mit welcher die Drucktaste (22) von dem Vorsprung (112) über die Ruhestellung hinaus entfernt würde, und um die gedruckte Schaltung (10) in dem Gehäuse (110) zu halten.

## Claims

1. Printed circuit (10) for an electrical unit (100) of a domestic electrical installation, said electrical unit (100) comprising a housing (110) including a protuberance (112) and a connection zone (114), said printed circuit (10) comprising a first face (12), a main section (20) and a connection section (30), said main section (20) comprising a push button (22) arranged on the first face (12), said connection section (30) forming an articulation (32) suitable for being connected to the connection zone (114) of the housing (110) so as to allow the pivoting of the main section (20) from a position of rest to a position of activation about the articulation (32) to bring the push button (22) to bear functionally against the protuberance (112) of the housing (110).

2. Printed circuit according to Claim 1, **characterized in that** the connection section (30) is flexible or pliable.

3. Printed circuit according to either one of Claims 1 and 2, **characterized in that** the main section (20) is provided with a first thickness and the connection section (30) is provided with a second thickness smaller than the first thickness, the ratio between the first thickness and the second thickness being preferentially greater than or equal to 2.

4. Printed circuit according to any one of Claims 1 to 3, **characterized in that** it further comprises a capacitive sensor (16) capable of detecting a movement of a finger of a user along a second face (14) of the printed circuit (10) opposite the first face (12) of the printed circuit (10).

5. Printed circuit according to any one of Claims 1 to 4, **characterized in that** the connection section (30) comprises at least a first essentially round orifice (34) and a second essentially oblong orifice (36), the first orifice (34) and the second orifice (36) each being capable of receiving a shoulder (116, 117) of the housing (110) in order to align the printed circuit (10) in the housing (110) in a connection position.

6. Printed circuit according to any one of Claims 1 to 5, **characterized in that** the housing (110) further comprises at least one abutment (118, 119) and the main section (20) comprises at least one abutment zone (24, 25) that can come to bear against the at least one abutment (118, 119) to prevent a pivoting of the main section (20) about the articulation (32) separating the push button (22) from the protuberance (112) beyond the position of rest in order to hold the printed circuit (10) in the housing (110).

7. Electrical unit intended to be installed in a domestic electrical installation, comprising a housing (110) and a printed circuit (10) according to any one of Claims 1 to 6, said housing (110) comprising a protuberance (112), the connection section (30) of the printed circuit (10) being connected to the housing (110) to form an articulation (32) about which the main section (20) can pivot from a position of rest to a position of activation to bring the push button (22) to bear functionally against the protuberance (112) of the housing (110).

8. Electrical unit according to Claim 7, **characterized in that** the protuberance (112) is formed by a screw (112a) screwed into the housing (110).

9. Electrical unit according to either one of Claims 7 and 8, **characterized in that** the housing (110) comprises a holding element (120) including a holding section (122) coming to bear against the connection section (30) in order to link the latter to the housing (110) to form the articulation (32), the holding element (120) being preferentially formed by a pane.

10. Electrical unit according to any one of Claims 6 to 9, **characterized in that** the housing comprises at least two shoulders (116, 117), the connection section comprising at least a first essentially round orifice (34) and a second essentially oblong orifice (36), the first orifice (34) and the second orifice (36) each receiving one of the shoulders (116, 117) of the housing (110) in order to align the printed circuit (10) in the housing (110) in a connection position.

11. Method for mounting an electrical unit (100) according to any one of Claims 6 to 10, **characterized by** the following steps which consist in:
a) making the housing (110) of the electrical unit (100) available;
b) making the printed circuit (10) of the electrical unit (100) available;
c) linking the connection section (30) of the printed circuit (10) to the housing (110) to form an articulation (32) about which the main section (20) of the printed circuit (10) can pivot to bring the push button (22) of the main section (20) from a position of rest to a position of activation bearing functionally against the protuberance (112) of the housing (110).

12. Method for mounting an electrical unit according to Claim 11, said electrical unit consisting of an electrical unit as defined in Claim 10, the method being **characterized in that** it further comprises the following steps of:
c1) introducing a first of the shoulders (116, 117) of the housing (110) into the second orifice (36) of the connection section (30) of the printed circuit (10) in order to link the connection section (30) of the printed circuit (10) to the housing to form the articulation (32);
c2) introducing a second of the shoulders (116, 117) of the housing (110) into the first orifice (34) of the connection section (30) of the printed circuit (10) in order to link the connection section (30) of the printed circuit (10) to the housing (110) to form the articulation (32).

13. Method for mounting an electrical unit according to either one of Claims 11 and 12, said electrical unit consisting of an electrical unit as defined in one of Claims 9 or 10, the method being **characterized in that** it further comprises the following steps of:
b1) making the holding element (120) available;
c5) pressing the holding section (122) of the holding element (120) against the connection section (30) of the printed circuit (10) in order to link the connection section (30) of the printed circuit (10) to the housing (110) to form the articulation (32).

14. Mounting method according to Claim 13, **characterized in that** it further comprises the following step of:
c4) applying an adhesive to the holding section (122) of the holding element (120) and/or to the holding element (120) and/or to the connection section (30) of the printed circuit (10) and/or to the housing (110) in order to adhere the holding section (122) of the holding element (120) to the connection section (30) of the printed circuit (10).

15. Mounting method according to any one of Claims 11 to 13, **characterized in that** it further comprises the following step of:
c3) juxtaposing at least one abutment zone (24, 25) of the main section (20) with at least one abutment (118, 119) of the housing (110) in order to prevent a pivoting of the main section (20) about the articulation (32) separating the push button (22) from the protuberance (112) beyond the position of rest and hold the printed circuit (10) in the housing (110).
